Europäisches Patentamt

European Patent Office

Office européen des brevets

(19)

(11) Veröffentlichungsnummer: **0 254 980 B1**

(12) # EUROPÄISCHE PATENTSCHRIFT

(45) Veröffentlichungstag der Patentschrift: **25.09.91**

(51) Int. Cl.⁵: **G11C 7/06, H03K 5/02**

(21) Anmeldenummer: **87110306.5**

(22) Anmeldetag: **16.07.87**

(54) **Integrierbare Bewerterschaltung.**

(30) Priorität: **24.07.86 DE 3625020**

(43) Veröffentlichungstag der Anmeldung:
**03.02.88 Patentblatt 88/05**

(45) Bekanntmachung des Hinweises auf die
Patenterteilung:
**25.09.91 Patentblatt 91/39**

(84) Benannte Vertragsstaaten:
**AT DE FR GB IT NL**

(56) Entgegenhaltungen:
**US-A- 4 162 539**

**PATENT ABSTRACTS OF JAPAN, Band 5, Nr.
82 (E-59)[754], 29. Mai 1981; & JP-A-56 30 321
(NIPPON DENKI K.K.) 26-03-1981**

**PATENT ABSTRACTS OF JAPAN, Band 7, Nr.
42 (P-177)[1187], 19. Februar 1983; & JP-A-57
191 890 (NIPPON DENKI K.K.) 25-11-1982**

(73) Patentinhaber: **Siemens Aktiengesellschaft
Wittelsbacherplatz 2
W-8000 München 2(DE)**

(72) Erfinder: **Kraus, Rainer. Dipl.-Phys.
Weidener Strasse 21
W-8000 München 83(DE)**

EP 0 254 980 B1

Rank Xerox (UK) Business Services

## Beschreibung

Die Erfindung betrifft eine integrierbare Bewerterschaltung nach dem Oberbegriff des Patentanspruches 1.

Gattungsgemäße integrierbare Bewerterschaltungen werden eingesetzt zur sicheren Erkennung und Unterscheidung logischer Pegel elektrischer Signale, insbesondere in Fällen, in denen sich die verschiedenen, zu bewertenden logischen Pegel spannungsmäßig nur sehr wenig voneinander unterscheiden. Am bekanntesten ist ihr Einsatz als sog. sense amplifier in integrierten Halbleiterspeichern wie beispielsweise in DRAM's und SRAM's. Stellvertretend für die vielen Veröffentlichungen, gattungsgemäße integrierbare Bewerterschaltungen betreffend, seien die folgenden genannt:

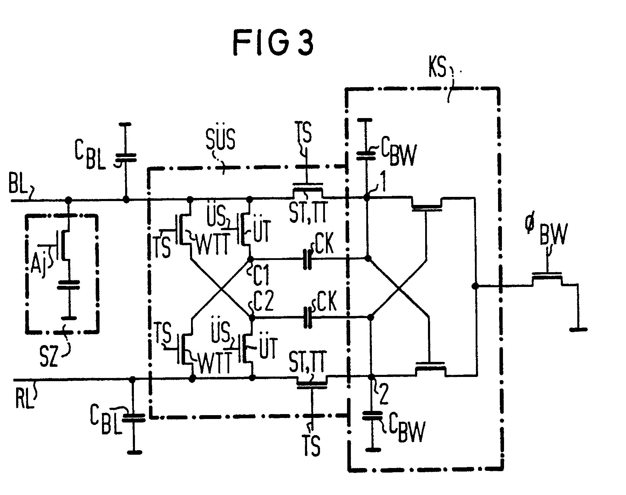

1) IEEE International Solid State Circuits Conference, 1980 Digest of Technical Papers, Seiten 228 bis 229, insbesondere Figur 3, ein DRAM zeigend und

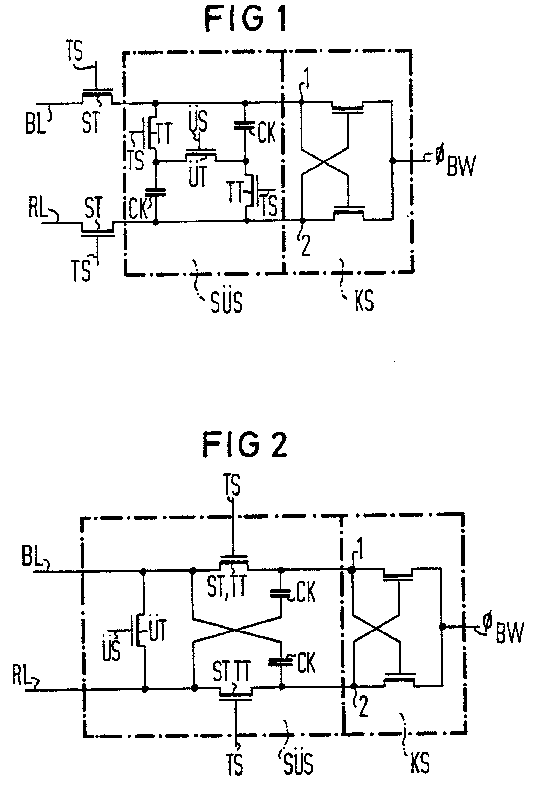

2) IEEE International Solid State Circuits Conference, 1984 Digest of Technical Papers, Seiten 226 bis 227, insbesondere Figur 2, ein SRAM zeigend.

Beide Schaltungen werden unter für gattungsgemäße integrierbare Bewerterschaltungen typischen Einsatzbedingungen betrieben: Die Bewerterschaltung, auch sense amplifier genannt, ist über Trenntransistoren mit einem Paar von Bitleitungen verbunden. Ihr wird im Lesebetrieb über eine der Bitleitungen ein aus einer adressierten Speicherzelle ausgelesenes Lesesignal zugeführt. Ein der anderen Bitleitung zuvor beispielsweise mittels einer Prechargeschaltung zugeführtes Potential behält zunächst seinen Wert bei oder es ändert sich geringfügig durch Verwendung einer sog. Dummyzelle. Dummyzellen sind Speicherzellen, die nicht der eigentlichen Informationsspeicherung dienen. Sie sind notwendig beim bekannten High- oder Lowpegel-Konzept zur Erzeugung eines Referenzsignals in Verbindung mit der bekannten Verwendung zweier eine bistabile Kippschaltung bildender kreuzweise gekoppelter Transistoren als Bewerterschaltung. Sie sind nicht notwendig, aber möglich beim bekannten Midpegel-Konzept (Symmetrisierung der Signale "logisch 0" und "logisch 1").

Die auftretende Problematik ist unabhängig von den verwendeten, bekannten Schaltungskonzepten immer gleich: Damit die Bewerterschaltung sicher anspricht und richtig bewertet, darf der auftretende Signalhub beim Auslesen einer Speicherzelle auf eine Bitleitung, die ja eine große kapazitive Belastung darstellt für das Lesesignal, eine bestimmte (kleine) Größe nicht unterschreiten. Bekannte Bewerterschaltungen haben beispielsweise eine Ansprechschwelle von 50mV, typische Lesesignalhübe bei guten Halbleiterspeichern liegen bei 150 +100mV. Bei Halbleiterspeichern ist die Größe des Lesesignales direkt proportional dem Speichervermögen der angeschlossenen Speicherzellen, im Falle dynamischer Halbleiterspeicher sogar direkt proportional der Kapazität jedes einzelnen Speicherzellenkondensators, und damit auch direkt proportional der Fläche, die jeder einzelne Speicherkondensator benötigt.

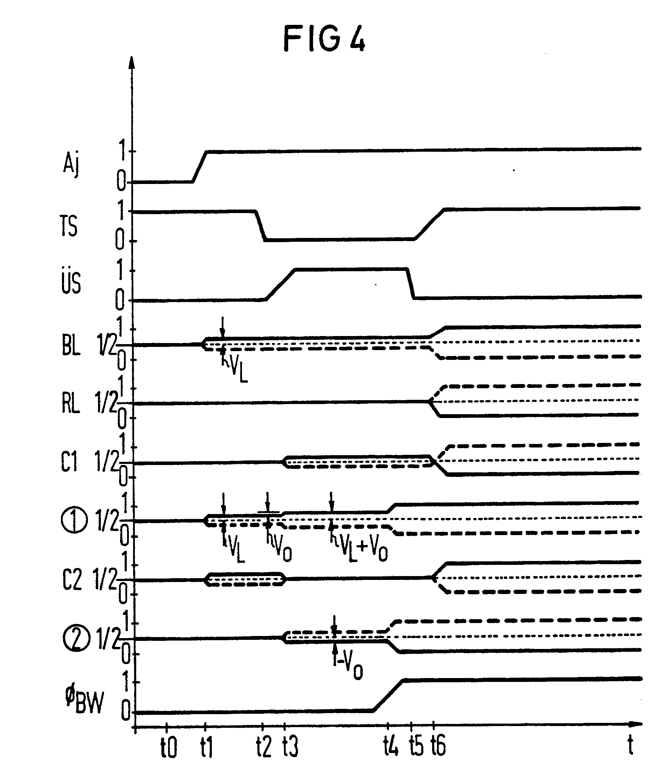

Aus "Patents Abstracts of Japan", Vol. 7, No. 42 (P-177) (1187) vom 19.02.1983 und zugehöriger JP-A-57-191890 ist eine Bewerter- und Verstärkerschaltung bekannt mit kreuzgekoppelten Transistoren sowie mit an diese über Schaltungsknoten angeschlossenen weiteren Transistoren. Bei jedem der weiteren Transistoren sind Source und Drain miteinander kurzgeschlossen. Gemäß dem Abstract in Verbindung mit Figur 4 der Offenlegungsschrift erfolgt im Betrieb zunächst eine Bewertung und Verstärkung eines Signals oder Potentialunterschiedes, das an zwei über Trenntransistoren angeschlossenen Leitungen an der Schaltung anliegt. Dadurch entsteht an einem der beiden Schaltungsknoten ein relativ hohes Potential, welches den an ihn angeschlossenen weiteren Transistor in einen Inversionszustand bringt. Am anderen der beiden Leitungsknoten entsteht ein niedriges Potential, so daß der daran angeschlossene weitere Transistor nicht in den Inversionszustand gelangt. Der im Inversionszustand befindliche weitere Transistor wirkt anschließend als Kapazität, nicht jedoch der nicht im Inversionszustand befindliche weitere Transistor. Bei einem dann erfolgenden Anlegen eines Taktsignales an beide weitere Transistoren erfährt das bereits relativ hohe Potential des einen Schaltungsknotens, an den der im Inversionsbetrieb befindliche weitere Transistor anliegt, eine Potentialverschiebung, so daß das Potential noch höher wird. Das Potential am anderen Schaltungsknoten hingegen bleibt unberührt, da der daran angeschlossene weitere Transistor nicht als Kapazität wirkt. Insgesamt bildet sich dadurch nach bereits erfolgtem Bewerten und Verstärken durch die Potentialverschiebung eine höhere Potentialdifferenz zwischen den beiden Schaltungsknoten aus als ohne die beiden weiteren Transistoren.

Aus "Patents Abstracts of Japan", Vol. 5, No. 82 (E-59) (754) vom 29.05.1981 und zugehöriger Japan-A-56-30321 ist eine hochempfindliche Verstärkerschaltung mit einem Differenzverstärker und beidseitig daran angeschlossenen Kondensatoren und Trenntransistoren bekannt. Die Kondensatoren liegen jeweils in Serie zwischen dem Differenzverstärker und einem der Trenntansistoren. Im Betrieb werden Bezugspotentiale, die gegebenenfalls gleich sein können, an den Differenzverstärker angelegt, nie jedoch die Eingangssignale. Anschließend erfolgt an jedem Eingang des Differenzverstärkers eine gegenläufige Potentialverschiebung.

Aufgabe der vorliegenden Erfindung ist es, eine gattungsgemäße Bewerterschaltung so weiterzubilden, daß auch auf Signalleitungen anliegende sehr kleine, von den bekannten Bewerterschaltungen nicht mehr bearbeitbare Lesesignale sicher erkannt und verstärkt werden können.

Diese Aufgabe wird erfindungsgemäß gelöst durch eine gattungsgemäße integrierbare Bewerterschaltung mit den kennzeichnenden Merkmalen des Patentanspruches 1.

Vorteilhafte Aus- und Weiterbildungen sind in Unteransprüchen gekennzeichnet.

Nachstehend werden verschiedene Ausbildungen der Erfindung anhand von Figuren näher erläutert.

Es zeigen dabei:
die Figuren 1 bis 3 verschiedene Ausbildungen der Erfindung,
die Figur 4 ein Impulsdiagramm.

Jede Ausführungsform der erfindungsgemäßen integrierbaren Bewerterschaltung enthält eine an sich bekannte Kippschaltung KS. Diese kann, wie allgemein üblich, aus zwei kreuzgekoppelten Transistoren gebildet sein, wobei beispielsweise die Sourcebereiche der beiden Transistoren elektrisch miteinander verbunden sind. Das elektrische Potential an dieser Verbindung ist veränderbar, damit die Bewertung durchgeführt werden kann. Es kann u.a. ein auf Referenzpotential schaltbares Bewertersignal $\emptyset_{BW}$ direkt angeschlossen sein (siehe Figuren 1,2) odes es kann ein Transistor angeschaltet sein, der mit dem Referenzpotential verbunden ist und der durch das Bewertersignal $\emptyset_{BW}$ gesteuert wird (vgl. Fig. 3). Es sind auch komplexe Funktionsgeneratoren bekannt, die einen speziellen Signalverlauf an der oben genannten Verbindung ermöglichen. Dies ist jedoch allgemein bekannt und nicht Bestandteil der Erfindung. Es ist lediglich aus Gründen der Vollständigkeit und zum leichteren Verständnis der Wirkungsweise der Erfindung erwähnt.

Die Kippschaltung KS weist einen ersten (1) und einen zweiten Schaltungsknoten 2 auf, die beide, wie üblich, hinsichtlich der Kippschaltung KS sowohl als Eingänge als auch als zueinander komplementäre Ausgänge dienen. Die beiden Schaltungsknoten 1,2, und damit auch die gesamte Kippschaltung KS sind jeweils über einen Schalttransistor ST, der gatemäßig von einem Trennsignal TS angesteuert wird, mit einem Paar von Signalleitungen BL, RL verbunden. In dem Falle, in dem die integrierbare Bewerterschaltung in einem Halbleiterspeicher eingebaut ist, wird dieses Paar von Signalleitungen BL,RL als Paar von Bitleitungen oder Paar von Bitleitung und Referenzleitung bezeichnet. Dies ist unabhängig davon, ob der Halbleiterspeicher nach dem Konzept der Folded-Bitline oder dem der Open-Bitline konzipiert ist. Im Falle eines Halbleiterspeichers sind mit jedem Signalleitungspaar im allgemeinen noch eine Precharge-Einrichtung, ggf. kombiniert mit einer Leitungs-Potential-Ausgleichs- oder Symetrierschaltung, sowie ggf. eine Rückschreibeinrichtung zum Zurückschreiben der aus einer Speicherzelle ausgelesenen Information verbunden. Diese Einrichtungen stehen jedoch in keiner direkten Verbindung mit der vorliegenden Erfindung. Sie sind deshalb und aus Übersichtlichkeitsgründen in den Figuren weggelassen. Ebenso sind (mit Ausnahme von Fig. 3) keine Signalquellen, die das zu bewertende Signal erzeugen wie beispielsweise Speicherzellen eingezeichnet.

Das Paar von Signalleitungen BL,RL weist in einem Ruhezustand kurz vor Auslesen eines Signales auf eine der Signalleitungen BL,RL untereinander gleiches Potential auf. Im Falle von Halbleiterspeichern ist dieses Potential bei traditionellen Designs (z.B. bei 64k-DRAM's und bei 256k-DRAM's) entweder das Bezugspotential Masse oder das Versorgungspotential $V_{CC}$. Mittlerweile setzt sich jedoch das sog. Mid-Level-Konzept immer mehr durch. In diesem Falle beträgt das obengenannte Potential, auf dem sich beide Signalleitungen BL,RL zunächst befinden, in etwa den halben Betrag der Versorgungsspannung. Für die vorliegende Erfindung ist es jedoch unerheblich, welchen Betrag das Potential auf den Signalleitungen BL,RL hat. Wichtig ist, daß das Potential auf beiden Signalleitungen BL,RL zumindest annähernd gleich ist (maximal zulässiger Unterschied 10mV).

Die bisher beschriebenen Merkmale der erfindungsgemäßen Bewerterschaltung, die in dieser Form in allen zu beschreibenden Ausführungsformen der Erfindung (Figuren 1 bis 3) enthalten sind, sind allgemein bekannt. Sie sind beispielsweise auch den eingangs genannten Veröffentlichungen entnehmbar.

Beim Gegenstand der vorliegenden Erfindung ist vorteilhafterweise zwischen der Kippschaltung KS und dem Paar von Signalleitungen BL,RL eine Signalüberhöhungsschaltung SÜS angeordnet.

Tritt auf einer der beiden Signalleitungen BL,RL, beispielsweise auf der Signalleitung BL, ein zu bewertendes Signal auf (im obengenannten Beispiel Halbleiterspeicher tritt dieser Zustand dann ein, wenn die in einer der Signalleitungen BL ( = Bitleitung) zugeordneten Speicherzelle eingespeicherte Information ausgelesen wird), so liegt dieses Signal mit seinem Signalhub $V_L$ (siehe Fig. 4) zunächst an dem mit der signalführenden Signalleitung BL verbundenen Schaltungsknoten (beispielsweise am ersten Schaltungsknoten 1). Erfindungsgemäß ist anschließend das Signal vom genannten Schaltungsknoten 1 elektrisch abgetrennt. Dies geschieht durch Sperren des an der einen Signalleitung BL befindlichen Schalttransistors ST mittels des Trennsignales TS.

Nach erfolgter Sperrung hebt anschließend die Signalüberhöhungsschaltung SÜS in vorteilhafter Art und Weise durch Potentialverschiebung das Potential am Schaltungsknoten 1, das sich ja aus dem Potential der ursprünglichen Vorladung und dem des Lesesignalhubes $V_L$ zusammensetzt, um einen Betrag $V_o$ an. Gleichzeitig wird das Potential am Schaltungsknoten 2 um denselben Betrag $V_o$ abgesenkt.

Die Kippschaltung KS, die ja bei bekannten Bewerterschaltungen im vorliegenden Falle einen Potentialunterschied von $V_L$ (= Signalhub) zwischen den beiden Schaltungsknoten 1,2 zu bewerten hätte, hat also im erfindungsgemäßen Fall an den Schaltungsknoten 1,2 bei unverändertem (Ursprungs-)Signal eine Potentialdifferenz von $V_L$ + $2V_o$ zwischen den beiden Schaltungsknoten 1,2 zum Bewerten zur Verfügung.

Entsprechendes gilt für ein zu bewertendes Signal mit negativem Signalhub $-V_L$.

Im folgenden werden einige vorteilhafte Ausführungen für die Signalüberhöhungsschaltung SÜS angegeben. Allen Ausführungsformen liegt dabei zugrunde, daß die Signalüberhöhungsschaltung SÜS wenigstens zwei Koppelkondensatoren CK aufweist. Der erste Anschluß des einen Koppelkondensators CK ist mit dem ersten Schaltungsknoten 1 verbunden. Der erste Anschluß des anderen Koppelkondensators CK ist mit dem zweiten Schaltungsknoten 2 verbunden. Die Signalüberhöhungsschaltung SÜS enthält des weiteren wenigstens einen Übertragungstransistor ÜT, dessen Gate als Steueranschluß mit einem Übertragungssignal ÜS verbunden ist. Die gesteuerten Anschlüsse Drain, Source jedes Übertragungstransistors ÜT sind jeweils mindestens mittelbar mit den zweiten Anschlüssen der Koppelkondensatoren CK verbunden. An die ersten Anschlüsse der Koppelkondensatoren CK ist jeweils ein Trenntransistor TT mit dem einen seiner gesteuerten Anschlüsse (z.B. Source) angeschlossen. Die Gates dieser Trenntransistoren TT sind mit einem Trennsignal TS verbunden. Der andere gesteuerte Anschluß (z.B. Drain) des einen der beiden Trenntransistoren TT ist mit dem zweiten Anschluß des anderen Koppelkondensators CK verbunden. Entsprechend ist der andere gesteuerte Anschluß (z.B. Drain) des anderen der beiden Trenntransistoren TT mit dem zweiten Anschluß des einen Koppelkondensators CK verbunden.

Nachfolgend wird die Wirkungsweise einer ersten Ausführungsform der Erfindung anhand von Figur 1 näher erläutert. In dieser Ausführungsform sind die Schalttransistoren ST mit ihren stromführenden Strecken zwischen dem Paar von Signalleitungen BL,RL einerseits und der Kippschaltung KS

samt der Signalüberhöhungsschaltung SÜS andererseits angeordnet. Die Wirkungsweise wird, wie auch nachfolgend bei den weiteren Ausführungsformen, anhand folgender konkreter Vorgaben und Annahmen erläutert: Das Paar von Signalleitungen BL,RL sei ein Bitleitungspaar eines Halbleiterspeichers, bestehend aus einer Bitleitung BL und einer Referenzleitung RL. Das Speicherzellenfeld des Halbleiterspeichers weise keine Dummyzellen auf (die erfindungsgemäße Schaltung funktioniert jedoch auch bei Dummyzellen). Als Bitleitung BL wird diejenige Signalleitung bezeichnet, auf der beim Auslesevorgang (durch Anwahl einer Speicherzelle über eine entsprechende Wortleitung) die ausgelesene Information als zu bewertendes Signal erscheint. Die andere, nicht ausgewählte Signalleitung wird als Referenzleitung RL bezeichnet. Eine weitere, für das Funktionieren der erfindungsgemäßen Schaltung nicht notwendige Annahme ist darin zu sehen, daß beide Signalleitungen BL,RL vor Beginn des Auslesevorganges jeweils das halbe Versorgungsspannungspotential aufweisen. Dies kann bekanntlich mittels einer sog. Precharge-Schaltung in Verbindung mit einer Symmetrierschaltung erfolgen.

Zu Beginn des Auslesevorganges sind das Trennsignal TS aktiv und das Übertragungssignal ÜS inaktiv. Die Schalttransistoren ST und die Trenntransistoren TT sind voll geöffnet, der Übertragungstransistor ÜT ist gesperrt. Am ersten Schaltungsknoten 1, am ersten Anschluß des einen Koppelkondensators CK und an einem der beiden gesteuerten Anschlüsse des Übertragungstransistors ÜT liegt das halbe Versorgungsspannungspotential (z.B. 2,5 V), verändert um das ausgelesene Lesesignal mit seinem Signalhub $V_L$ (z.B. 150mV). Wurde eine logische "1" ausgelesen (bei Verwendung von n-Kanal-Transistoren und positiver Logik), so ist das anliegende Potential um den Lesesignalhub $V_L$ erhöht, ansonsten (logisch "0") entsprechend erniedrigt.

Am zweiten Schaltungsknoten 2, am ersten Anschluß des anderen Koppelkondensators CK und am anderen der beiden gesteuerten Anschlüsse des Übertragungstransistors ÜT liegt unverändert das halbe Versorgungsspannungspotential von beispielsweise 2,5 V an. Die Kippschaltung KS wird, wie dem Fachmann geläufig, beispielsweise über das Bewertersignal $\phi_{BW}$ in einem labilen Gleichgewichtszustand gehalten.

Das Trennsignal TS nimmt dann seinen inaktiven Zustand ein, worauf die Schalttransistoren ST und die Trenntransistoren TT sperren. Nach erfolgter Sperrung wird das Übertragungssignal ÜS aktiviert, woraufhin der Übertragungstransistor ÜT durchschaltet. Während des (möglichst kurzen) Zeitraumes, in dem das Trennsignal TS (bereits) deaktiviert war und das Übertragungssignal ÜS (noch) deaktiviert war, lag an dem einen gesteuerten Anschluß des Übertragungstransistors ÜT ein um den Betrag des Lesesignalhubes $V_L$ erhöhtes (bzw. im Fall des Auslesens einer logischen "0" erniedrigtes) Potential, verglichen mit dem Potential am anderen gesteuerten Anschluß des Übertragungstransistors ÜT. Durch das Aktivieren des Übertragungssignales ÜS erfolgt über den Übertragungstransistor ÜT ein Potentialausgleich, was einen Potentialanstieg am anderen gesteuerten Anschluß des Übertragungstransistors ÜT, und somit auch am zweiten Anschluß des mit dem ersten Schaltungsknoten 1 verbundenen Koppelkondensators CK zur Folge hat. Dieser Potentialanstieg wiederum wirkt sich über den Koppelkondensator CK auf den ersten Schaltungsknoten 1 aus und erhöht dessen Potential, das bis dahin den Wert "halbes Versorgungsspannungspotential + Lesesignalhub $V_L$" aufwies. Die maximal mögliche Potentialerhöhung beträgt in etwa 1/4 des Lesesignalhubes $V_L$. Durch den beschriebenen Potentialausgleich nimmt jedoch das Potential am einen gesteuerten Anschluß des Übertragungstransistors ÜT um denselben Betrag ab, wie es am anderen gesteuerten Anschluß des Übertragungstransistors ÜT zunimmt. Dies jedoch wirkt sich auf den zweiten Schaltungsknoten 2 über den ihm zugeordneten Koppelkondensator CK aus, d.h. das Potential am zweiten Schaltungsknoten 2 nimmt (bei angenommener gleicher Dimensionierung der beiden Koppelkondensatoren CK) um denselben Betrag ab wie das Potential am ersten Schaltungsknoten 1 zunimmt.

Insgesamt läßt sich bei dieser Ausführungsform eine Potentialdifferenz zwischen den beiden Schaltungsknoten 1 und 2 erreichen in Höhe von "Lesesignalhub $V_L$ + (2 mal Potentialerhöhung $V_0$)". Mit den zuvor angegebenen Werten ($V_L$ = 150mV, Potentialerhöhung $V_0$ = $V_L/4$) entsteht eine durch die Kippschaltung KS zu bewertende Potentialdifferenz von 225mV. Dies erhöht also die Sicherheit hinsichtlich richtigen Bewertens enorm. Andererseits kann jedoch der Schaltungsentwickler die Vorteile der erfindungsgemäßen Bewerterschaltung dahingehend ausnützen, daß er die die zu bewertenden Signale erzeugenden Schaltungsteile (im Beispiel: die Speicherzellen) so dimensioniert, daß kleinere Signale entstehen.Bei dynamischen Halbleiterspeichern bedeutet dies, daß der Schaltungsentwickler Speicherzellen entsprechend geringerer Kapazitäten verwendet. Da die Kapazitätswerte direkt proportional dem Flächenbedarf der zugeordneten Kondensatoren sind, kann er somit auch Fläche einsparen. Dies ist ein ganz wichtiger Aspekt moderner integrierter Schaltkreistechnik.

Bei den Ausführungsformen nach den Figuren 2 und 3 dienen die Schalttransistoren ST erfindungsgemäß gleichzeitig als Trenntransistoren TT.

Die vorteilhafte Ausführungsform nach Fig. 2 basiert auf demselben Schaltungsprinzip wie die nach Fig. 1: Zunächst wird der Schaltungsknoten 1 auf das um den Betrag des Signalhubes $V_L$ des zu bewertenden Signales erhöhte bzw. erniedrigte ursprünglich halbe Versorgungspotential gebracht unter Beibehaltung des halben Versorgungspotentiales am Schaltungsknoten 2. Anschließend werden die Trenntransistoren TT, die in der Ausführungsform nach Figur 2 identisch sind mit den Schalttransistoren ST bekannter bewährter Schaltungen, gesperrt und der Übertragungstransistor ÜT leitend geschaltet. Dadurch findet über die gesteuerte Strecke (Drain - Source) des Übertragungstransistors ÜT ein Potentialausgleich statt. Dies hat einen Potentialanstieg am zweiten Anschluß des an seinem ersten Anschluß mit dem ersten Schaltungspunkt 1 verbundenen Koppelkondensators CK zur Folge und weiterhin am ersten Schaltungsknoten 1 selbst. Der Potentialausgleich über den Übertragungstransistor ÜT bewirkt gleichzeitig ein Absinken des Potentiales am zweiten Anschluß des mit seinem ersten Anschluß mit dem zweiten Schaltungsknoten 2 verbundenen Koppelkondensators CK, wodurch am zweiten Schaltungsknoten 2 selbst auch eine Potentialverringerung eintritt. Die sich zwischen den beiden Schaltungsknoten 1,2 einstellende Potentialdifferenz, die ja anschließend durch die Kippschaltung KS (ausgelöst durch Verändern des Bewertersignales $\phi_{BW}$) zu bewerten ist, ist durch die geschilderten vorteilhaften Schaltungsmaßnahmen, ähnlich wie bei der Ausgestaltung nach Fig. 1, gegenüber den bekannten Bewerterschaltungen vergrößert, was auch die bezüglich Fig.1 angeführten Vorteile zur Folge hat.

Die vorteilhafte Ausführung gemäß Fig. 3 ist hinsichtlich der erzielbaren Signalüberhöhung optimiert, d.h. die Potentialerhöhung (bzw. -erniedrigung) $V_0$ ist größer als bei den vorstehend beschriebenen Ausgestaltungen. Entsprechend lassen sich bei einem Halbleiterspeicher auch die Speicherzellen des Speicherzellenfeldes nochmals verkleinern. Nachstehend wird diese Ausführungsform in Verbindung mit dem (stark schematisiert dargestellten) Impulsdiagramm nach Fig. 4 näher erläutert:

Es gilt wiederum die Annahme, daß die erfindungsgemäße Bewerterschaltung bei einem Halbleiterspeicher verwendet wird zum Bewerten einer aus einer Speicherzelle SZ ausgelesenen Information als zu bewertendes Signal (allgemein als "Lesesignal" bezeichnet), wobei die Speicherzelle SZ an die Bitleitung BL angeschlossen ist. Der Wert der logischen Information beträgt "1". Die Potentialverläufe bei Auslesen einer logischen "0" sind, soweit sie sich von denen beim Auslesen der logischen "1" unterscheiden, gestrichelt dargestellt. Das angenommene halbe Versorgungsspannungspotential ist, soweit durch das Auslesen und Bewerten ein Abweichen davon verursacht ist, punktiert gezeichnet und mit der Bezeichnung "1/2" versehen.

Die integrierbare Bewerterschaltung weist gegenüber den bisher erläuterten Ausführungsformen wenigstens einen weiteren Übertragungstransistor ÜT auf, dessen Gate als Steueranschluß ebenfalls mit dem Übertragungssignal ÜS verbunden ist. Der eine gesteuerte Anschluß (Drain) der Übertragungstransistoren ÜT ist jeweils mit dem zweiten Anschluß eines der Koppelkondensatoren CK verbunden. Diese beiden weiteren Verbindungspunkte sind in Fig. 3 mit C1 bzw. C2 bezeichnet. Der andere gesteuerte Anschluß (Source) des einen der Übertragungstransistoren ÜT ist sowohl mit dem anderen gesteuerten Anschluß des einen der beiden Trenntransistoren TT als auch über den stromführenden Pfad (Kanal) eines ersten weiteren Trenntransistors WTT mit dem zweiten Anschluß des anderen Koppelkondensators CK verbunden (weiterer Verbindungspunkt C2). Entsprechend ist der andere gesteuerte Anschluß (Source) des weiteren der Übertragungstransistoren ÜT sowohl mit dem anderen gesteuerten Anschluß des anderen der beiden Trenntransistoren TT als auch über den stromführenden Pfad (Kanal) eines zweiten weiteren Trenntransistors WTT mit dem zweiten Anschluß des einen Koppelkondensators CK verbunden (weiterer Verbindungspunkt C1). Ebenso wie bei der Ausführungsform nach Fig. 2 dienen die Schalttransistoren ST gleichzeitig als Trenntransistoren TT.

Zu Beginn eines Auslese- und Bewertungszyklus (in Fig. 4 mit dem Zeitpunkt t0 bezeichnet) sind die folgenden Signale auch im elektrisch inaktiven Zustand logisch "0": (Wort-)Auswahlleitung Aj zur Auswahlansteuerung für eine Speicherzelle SZ, Übertragungssignal ÜS, Bewertersignal $\phi_{BW}$. Lediglich das Trennsignal TS ist elektrisch aktiv auf logisch "1".

Zu einem Zeitpunkt t1 wird über die (Wort-)Auswahlleitung Aj genau eine Speicherzelle SZ der Bitleitung BL auf diese ausgelesen. Es wird im folgenden, wie bereits erläutert, angenommen, daß eine logische "1" ausgelesen wird. Das Lesesignal weise den Signalhub $V_L$ auf. Bis zum Zeitpunkt t1 wiesen folgende Leitungen und Schaltungsknoten vereinbarungsgemäß das halbe Versorgungsspannungspotential ("1/2") auf: Bitleitung BL, Referenzleitung RL, (weitere) Schaltungsknoten C1,C2, 1 und 2. Mit erfolgtem Auslesen nehmen die Bitleitung BL, der erste Schaltungsknoten 1 (Schalt- bzw. Trenntransistoren ST,TT sind wegen Trennsignal TS durchgeschaltet) und der weitere Schaltungsknoten C2 (der erste weitere Trenntransistor WTT ist wegen des Trennsignales TS durchgeschaltet) das Potential "1/2 mal Versorgungsspannung + Signalhub $V_L$" an, was bei Auslesen einer logischen "1" eine Potentialerhöhung und im Falle des Auslesens einer logischen "0" eine Potentialerniedrigung bedeutet. Die Potentiale der Referenzleitung RL, des zweiten Schaltungsknotens 2 und das des weiteren Schaltungsknotens C1 bleiben unverändert (der zweite weitere Trenntransistor WTT ist leitend wegen Trennsignal TS).

Zum Zeitpunkt t2 wird das Trennsignal TS elektrisch inaktiv, die Trenntransistoren TT und die weiteren Trenntransistoren WTT sperren. Möglichst bald darauf, jedoch frühestens nach erfolgter Sperrung, wird das Übertragungssignal ÜS zum Zeitpunkt t3 elektrisch aktiv, d.h. die Übertragungstransistoren ÜT werden leitend geschaltet. Über die Übertragungstransistoren ÜT erfolgt nun ein Potentialausgleich zwischen Bitleitung BL und weiterem Schaltungsknoten C1 sowie zwischen Referenzleitung RL und weiterem Schaltungsknoten C2. Die, verglichen mit den Kapazitäten der Speicherzellen SZ, denen der Koppelkondensatoren CK und der Eigenkapazität $C_{BW}$ der Bewerterschaltung, sehr großen Bit- und Referenzleitungskapazitäten $C_{BL}$ bewirken, daß die Bitleitung BL und die Referenzleitung RL ihr Potential nur unwesentlich verändern. Dies wiederum bewirkt, daß der weitere Schaltungsknoten C1 potentialmäßig angehoben wird (bei logisch "0": abgesenkt), während der weitere Schaltungsknoten C2 wiederum in etwa das Mittenpotential "1/2 Versorgungsspannung" annimmt. Letzteres bedeutet im Falle einer logischen "1" ein Absenken, im Falle einer logischen "0" ein Anheben des Potentiales. Die Potentialveränderungen an den weiteren Schaltungsknoten C1 und C2 bewirken über die Koppelkondensatoren CK eine entsprechende Potentialveränderung an den beiden Schaltungsknoten 1 und 2. Der erste Schaltungsknoten 1 wird um einen Betrag $V_0$ angehoben ($V_0 < V_L$; abgesenkt im Falle von logisch "0"), wogegen der zweite Schaltungsknoten 2 um denselben Betrag $V_0$ (in dem Falle, in dem die Koppelkondensatoren CK gleiche Kapazitätswerte aufweisen) abgesenkt wird. Zwischen den beiden Schaltungsknoten 1 und 2 entsteht also eine Spannung ("Potential an Schaltungsknoten 1") - ("Potential an Schaltungsknoten 2") = ("1/2" + $V_L$ + $V_0$) - ("1/2" - $V_0$) = $V_L$ + $2V_0$. Dieser Wert wird auch erreicht beim Auslesen einer logischen "0", was nachzuvollziehen dem Fachmann keine Mühe macht und auch aus Fig. 4 ersichtlich ist (gestrichelte Werte).

Wie eingangs erwähnt, beträgt der Lesesignalhub herkömmlicher Halbleiterspeicherzellen ca. 150mV. Die Signalüberhöhungsschaltung SÜS der erfindungsgemäßen Bewerterschaltung ermöglicht eine Potentialänderung um $V_0 = V_L/2$ je Signalleitung d.h. der Kippschaltung KS steht (bei unveränderten Speicherzellenkapazitäten) zwischen beiden Signalleitungen ein Lesesignal mit doppelter Amplitude zum Bewerten zur Verfügung ($V_L + 2(V_L/2)$).

Die Kippschaltung KS wird, wie allgemein bekannt, bis zum Zeitpunkt t4 in einem Zustand labilen Gleichgewichtes gehalten. Zum Zeitpunkt t4 wird sie mittels eines Bewertersignales $\emptyset_{BW}$ (ob direkt durch das Bewertersignal, ob indirekt über einen Transistor wie in Fig. 3, oder ob durch einen komplizierten Funktionsgenerator veranlaßt, ist für die vorliegende Erfindung nicht von Bedeutung) aktiviert. Damit wird die ursprünglich ausgelesene Information bewertet, die beiden Schaltungsknoten 1,2 nehmen die vollen logischen Pegel "1" bzw. "0" an.

Zum Zeitpunkt t5 werden die Übertragungstransistoren ÜT durch Deaktivieren des Übertragungssignales ÜS wieder gesperrt. Anschließend, zum Zeitpunkt t6, wird das Trennsignal TS elektrisch aktiv, die Trenntransistoren TT und die weiteren Trenntransistoren WTT werden leitend. Entsprechend nehmen der weitere Schaltungsknoten C1 das Potential der Referenzleitung RL an und der weitere Schaltungsknoten C2 das Potential der Bitleitung BL. Unabhängig von dem Geschehen an den weiteren Schaltungsknoten C1 und C2 kann die Information am ersten Schaltungsknoten 1 ( = logisch "1" im Beispiel) über die Bitleitung mit Hilfe einer (nicht dargestellten) Refresh-Schaltung in die Speicherzelle zurückgeschrieben werden. Dieser Vorgang ist bereits bekannt.

Wenn auch die vorliegende Erfindung anhand des Auslesens von Informationen auf die Bitleitung BL beschrieben wird, so ist es doch dem Fachmann einleuchtend, daß die Begriffe Bitleitung BL und Referenzleitung RL hinsichtlich der Bewerterschaltung vertauschbar sind, ohne daß dies den geringsten Einfluß auf das Funktionieren der Schaltung hat.

Es hat sich als vorteilhaft erwiesen, daß die Kapazitätswerte der Koppelkondensatoren CK untereinander gleich sind.

Es hat sich ebenfalls als vorteilhaft erwiesen, daß die Kapazitätswerte der Koppelkondensatoren CK in etwa gleich der Eigenkapazität $C_{BW}$ der Kippschaltung KS sind.

Empfehlenswert ist aufgrund der derzeit realisierbaren Eigenkapazität $C_{BW}$ der Kippschaltung KS in Höhe von 20 bis 40fF, daß die Koppelkondensatoren Kapazitätswerte von 20 bis 40fF aufweisen.

Es ist auch vorteilhaft, die Übertragungstransistoren ÜT frühestens dann leitend zu schalten, wenn die Trenntransistoren TT und die weiteren Trenntransistoren WTT sicher gesperrt sind.

Es ist weiterhin vorteilhaft, daß diejenige Flanke des Übertragungssignales ÜS, die dieses in den aktiven Zustand bringt (und damit die Übertragungstransistoren ÜT leitend schaltet), eine geringere Flankensteilheit aufweist als die entsprechend entgegengesetzte Flanke.

Weiterhin ist es auch vorteilhaft, daß diejenige Flanke des Trennsignales TS, die dieses in den aktiven Zustand bringt (und damit die Trenntransistoren TT und ggf. die weiteren Trenntransistoren WTT leitend schaltet), eine geringere Flankensteilheit aufweist als die entsprechend entgegengesetzte Flanke.

## Patentansprüche

1. Integrierbare Bewerterschaltung
   - mit einer Kippschaltung (KS),
   - mit einem ersten und einem zweiten Schaltungsknoten (1, 2), die beide der Kippschaltung (KS) sowohl als Eingänge als auch als zueinander komplementäre Ausgänge dienen,
   - beide Schaltungsknoten (1, 2) sind über gemeinsam gesteuerte Schalttransistoren (ST) mit einem Paar von Signalleitungen (BL, RL) verbunden,
   - das Paar von Signalleitungen (BL, RL) weist in einem Ruhezustand das gleiche Potential auf,

**gekennzeichnet durch**
folgende Merkmale:
   - zwischen der Kippschaltung (KS) und dem Paar von Signalleitungen (BL, RL) ist eine durch ein Übertragungssignal (ÜS) gesteuerte Signalüberhöhungsschaltung (SÜS) angeordnet,
   - bei Auftreten eines Signales auf einer (BL; RL) der beiden Signalleitungen (BL, RL) liegt dieses mit seinem Signalhub ($V_L$) zunächst an demjenigen Schaltungsknoten (1; 2), der mit der signalführenden Signalleitung (BL; RL) verbunden ist,
   - anschließend ist das Signal von dem genannten Schaltungsknoten (1; 2) durch Sperren des der signalführenden Signalleitung (BL; RL) zugeordneten Schalttransistors (ST) abgetrennt,
   - durch anschließendes Aktivieren des Übertragungssignals (ÜS) bewirkt die Signalüberhöhungsschaltung (SÜS) bei positivem Signalhub des Signals durch Potentialverschiebung mittels Koppelkondensatoren (CK) eine Anhebung des Potentials am genannten Schaltungsknoten (1; 2) um einen Betrag ($V_o$) und gleichzeitig eine Verringerung des Potentials am anderen (2; 1) der beiden Schaltungsknoten (1, 2), so daß an den Schaltungsknoten (1, 2) der Kippschaltung (KS) eine gegenüber dem Signalhub ($V_L$; $-V_L$) vergrößerte Potentialdifferenz zum Bewerten und Verstärken anliegt,
   - liegt als Signal ein solches mit negativem Signalhub (-V$_L$) vor, so bewirkt die Signalüberhöhungsschaltung (SÜS) am genannten Schaltungsknoten (1; 2) eine Potentialabsenkung und am anderen der beiden Schaltungsknoten (2; 1) eine Potentialanhebung bei Aktivieren des Übertragungssignales (ÜS).

2. Integrierbare Bewerterschaltung nach Anspruch 1,
**dadurch gekennzeichnet,**
- daß die Signalüberhöhungsschaltung (SÜS) wenigstens zwei Koppelkondensatoren (CK) aufweist,
- daß ein erster Anschluß des einen der beiden Koppelkondensatoren (CK) mit dem ersten Schaltungsknoten (1) und ein erster Anschluß des anderen der beiden Koppelkondensatoren (CK) mit dem zweiten Schaltungsknoten (2) verbunden ist,
- daß die Signalüberhöhungsschaltung (SÜS) einen Übertragungstransistor (ÜT) aufweist,
  - dessen Gate als Steueranschluß mit einem Übertragungssignal (ÜS) verbunden ist,
  - dessen gesteuerte Anschlüsse (Drain,Source) jeweils mit einem zweiten Anschluß der Koppelkondensatoren (CK) verbunden sind,
- daß an den ersten Anschluß der Koppelkondensatoren (CK) jeweils ein Trenntransistor (TT) mit einem seiner gesteuerten Anschlüsse (Source,Drain) angeschlossen ist,
  - dessen Gate mit einem Trennsignal (TS) beaufschlagt ist,
  - daß der andere gesteuerte Anschluß (Drain,Source) des einen der beiden Trenntransistoren (TT) mit dem zweiten Anschluß des anderen Koppelkondensators (CK) verbunden ist,
  - und daß der andere gesteuerte Anschluß (Drain,Source) des anderen der beiden Trenntransistoren (TT) mit dem zweiten Anschluß des einen Koppelkondensators (CK) verbunden ist.

3. Integrierbare Bewerterschaltung nach Anspruch 2,
**dadurch gekennzeichnet,**
daß die Schalttransistoren (ST) mit ihrem stromführenden Pfad zwischen dem Paar von Signalleitungen (BL,RL) einerseits und der Kippschaltung (KS) samt der Signalüberhöhungsschaltung (SÜS) andererseits angeordnet ist.

4. Integrierbare Bewerterschaltung nach Anspruch 2,
**dadurch gekennzeichnet,**
- daß die Signalüberhöhungsschaltung (SÜS) wenigstens einen weiteren Übertragungstransistor (ÜT) aufweist, dessen Gate als Steueranschluß mit dem Übertragungssignal (ÜS) verbunden ist,
- daß der eine gesteuerte Anschluß jedes Übertragungstransistors (ÜT) jeweils mit dem zweiten Anschluß eines der Koppelkondensatoren (CK) verbunden ist,
- daß der andere gesteuerte Anschluß des einen Übertragungstransistors (ÜT) sowohl mit dem anderen gesteuerten Anschluß des einen der beiden Trenntransistoren (TT) als auch über den stromführenden Pfad (Kanal) eines ersten weiteren Trenntransistors (WTT) mit dem zweiten Anschluß des anderen Koppelkondensators (CK) verbunden ist,
- daß der andere gesteuerte Anschluß des weiteren Übertragungstransistors (ÜT) sowohl mit dem anderen gesteuerten Anschluß des anderen der beiden Trenntransistoren (TT) als auch über den stromführenden Pfad (Kanal) eines zweiten weiteren Trenntransistors (WTT) mit dem zweiten Anschluß des einen Koppelkondensators (CK) verbunden ist.

5. Integrierbare Bewerterschaltung nach Anspruch 2 oder 4,
**dadurch gekennzeichnet,**
daß als Trenntransistoren (TT) die Schalttransistoren (ST) dienen.

6. Integrierbare Bewerterschaltung nach einem der vorhergehenden Ansprüche,
**dadurch gekennzeichnet,**
daß die Kapazitätswerte der Koppelkondensatoren (CK) untereinander gleich sind.

7. Integrierbare Bewerterschaltung nach einem der vorhergehenden Ansprüche,
**dadurch gekennzeichnet,**
daß die Kapazitätswerte der Koppelkondensatoren (CK) in etwa gleich der Eigenkapazität (C$_{BW}$) der Kippschaltung (KS) sind.

8. Integrierbare Bewerterschaltung nach Anspruch 7,
**dadurch gekennzeichnet,**
daß die Kapazitätswerte der Koppelkondensatoren (CK) 20 bis 40fF betragen.

9. Integrierbare Bewerterschaltung nach einem der vorhergehenden Ansprüche,

**dadurch gekennzeichnet,**

daß die Übertragungstransistoren (ÜT) frühestens dann leitend geschaltet sind, wenn die Trenntransistoren (TT; TT, WTT) gesperrt sind.

10. Integrierbare Bewerterschaltung nach einem der vorhergehenden Ansprüche,

**dadurch gekennzeichnet,**

daß diejenige Flanke des Übertragungssignales (ÜS), die dieses in den aktiven Zustand bringt, eine geringere Flankensteilheit aufweist als die entsprechend entgegengesetzte Flanke.

11. Integrierbare Bewerterschaltung nach einem der vorhergehenden Ansprüche,

**dadurch gekennzeichnet,**

daß diejenige Flanke des Trennsignales (TS), die dieses in den aktiven Zustand bringt, eine geringere Flankensteilheit aufweist als die entsprechend entgegengesetzte Flanke.

## Claims

1. Integrable evaluating circuit
   - comprising a trigger circuit (KS),
   - comprising a first and a second circuit node (1, 2) both of which serve the trigger circuit (KS) both as inputs and as mutually complementary outputs,
   - both circuit nodes (1, 2) being connected via jointly controlled switching transistors (ST) to a pair of signal lines (BL, RL),
   - the pair of signal lines (BL, RL) exhibiting the same potential in a rest state,

   characterised by the following features:
   - a signal enhancement circuit (SÜS) controlled by a transfer signal (ÜS) is arranged between the trigger circuit (KS) and the pair of signal lines (BL, RL),
   - upon the occurrence of a signal on one (BL; RL) of the two signal lines (BL, RL), the said signal is initially connected with its signal deviation ($V_L$) to that circuit node (1; 2) which is connected to the signal-carrying signal line (BL; RL),
   - the signal is subsequently isolated from the said circuit node (1; 2) by blocking the switching transistor (ST) assigned to the signal-carrying signal line (BL; RL),
   - by subsequently activating the transfer signal (ÜS) in the case of a positive signal deviation of the signal, the signal enhancement circuit (SÜS) effects through a potential shift by means of coupling capacitors (CK) an increase in the potential at the said circuit node (1; 2) by an amount ($V_o$), and simultaneously a reduction in the potential at the other (2; 1) of the two circuit nodes (1, 2), so that a potential difference which is enlarged with respect to the signal deviation ($V_L$; $-V_L$) is connected to the circuit nodes (1, 2) of the trigger circuit (KS) for the purpose of evaluation and amplification,
   - if the signal that is present is one having a negative signal deviation ($-V_L$), the signal enhancement circuit (SÜS) effects a potential drop at the said circuit node (1; 2) and a potential increase at the other of the two circuit nodes (2; 1) in the case of activation of the transfer signal (ÜS).

2. Integrable evaluating circuit according to Claim 1, characterised in that
   - the signal enhancement circuit (SÜS) exhibits at least two coupling capacitors (CK),
   - a first terminal of one of the two coupling capacitors (CK) is connected to the first circuit node (1), and a first terminal of the other of the two coupling capacitors (CK) is connected to the second circuit node (2),
   - the signal enhancement circuit (SÜS) exhibits a transfer transistor (ÜT)
     - whose gate is connected as control terminal to a transfer signal (ÜS), and
     - whose controlled terminals (drain, source) are respectively connected to a second terminal of the coupling capacitors (CK),
   - connected in each case to the first terminal of the coupling capacitors (CK) by means of one of its controlled terminals (source, drain) is an isolating transistor (TT)
     - whose gate receives an isolating signal (TS),
   - the other controlled terminal (drain, source) of one of the two isolating transistors (TT) is connected to the second terminal of the other coupling capacitor (CK), and in that
   - the other control terminal (drain, source) of the other of the two isolating transistors (TT) is connected to the second terminal of one coupling capacitor (CK).

3. Integrable evaluating circuit according to Claim 2, characterised in that the switching transistors (ST) are arranged with their current-carrying path between the pair of signal lines (BL, RL), on the one hand, and the trigger circuit (KS) together with the signal enhancement circuit (SÜS), on the other hand.

4. Integrable evaluating circuit according to Claim 2, characterised in that
   - the signal enhancement circuit (SÜS) exhibits at least one further transfer transistor (ÜT), whose gate is connected as control terminal to the transfer signal (ÜS),
   - one controlled terminal of each transfer transistor (ÜT) is connected in each case to the second terminal of one of the coupling capacitors (CK),
   - the other controlled terminal of one transfer transistor (ÜT) is connected both to the other controlled terminal of one of the two isolating transistors (TT) and, via the current-carrying path (channel) of a first further isolating transistor (WTT), to the second terminal of the other coupling capacitor (CK),
   - the other controlled terminal of the further transfer transistor (ÜT) is connected both to the other controlled terminal of the other of the two isolating transistors (TT) and, via the current-carrying path (channel) of a second further isolating transistor (WTT), to the second terminal of one coupling capacitor (CK).

5. Integrable evaluating circuit according to Claim 2 or 4, characterised in that the switching transistors (ST) serve as isolating transistors (TT).

6. Integrable evaluating circuit according to one of the preceding claims, characterised in that the capacitance values of the coupling capacitors (CK) are equal to one another.

7. Integrable evaluating circuit according to one of the preceding claims, characterised in that the capacitance values of the coupling capacitors (CK) are approximately equal to the self-capacitance ($C_{BW}$) of the trigger circuit (KS).

8. Integrable evaluating circuit according to Claim 7, characterised in that the capacitance values of the coupling capacitors (CK) are 20 to 40 fF.

9. Integrable evaluating circuit according to one of the preceding claims, characterised in that the transfer transistors (ÜT) are switched into conductivity at the earliest when the isolating transistors (TT; TT, WTT) are blocked.

10. Integrable evaluating circuit according to one of the preceding claims, characterised in that that edge of the transfer signal (ÜS) which brings the latter into the active state exhibits a lower edge steepness than the corresponding opposing edge.

11. Integrable evaluating circuit according to one of the preceding claims, characterised in that that edge of the isolating signal (TS) which brings the latter into the active state exhibits a lower edge steepness than the corresponding opposing edge.

**Revendications**

1. Circuit intégrable d'évaluation
   - comportant un circuit à bascule (KS),
   - des premier et second noeuds (1,2) du circuit, qui sont utilisés tous deux aussi bien comme entrées que comme sorties, complémentaires entre elles, du circuit à bascule (KS),
   - ces deux noeuds (1,2) du circuit sont raccordés à un couple de conducteurs de transmission de signaux (BL,RL), par l'intermédiaire de transistors de commutation (ST) commandés en commun,
   - le couple de conducteurs de transmission de signaux (BL,RL) possède le même potentiel à l'état de repos,
   caractérisé par les caractéristiques suivantes:
   - un circuit (SÜS) d'amplification des signaux, commandé par un signal de transmission (ÜS) est disposé entre le circuit à bascule (KS) et le couple de conducteurs de transmission de signaux (BL,RL),
   - lors de l'apparition d'un signal dans l'un (BL;RL) des deux conducteurs de transmission de signaux (BL,RL), ce signal est appliqué tout d'abord, avec son excursion ($V_L$), au noeud (1;2) du circuit, qui est raccordé au conducteur de transmission de signaux (BL;RL), qui véhicule ce signal,
   - et ensuite le signal est supprimé dudit noeud (1;2) du circuit par blocage du transistor de commutation (ST) associé au conducteur de transmission de signaux (BL;RL) véhiculant ce signal,
   - dans le cas d'une excursion positive de ce signal, le circuit (SÜS) d'amplification du signal réalise, au moyen d'une activation ultérieure du signal de transmission (ÜS), et au moyen d'un décalage de potentiel à l'aide de condensateurs de couplage (CK), un accroissement du potentiel sur ledit noeud (1;2) du circuit, et ce d'une valeur ($V_o$), et simultanément une réduction du potentiel sur l'autre (2;1) des deux noeuds (1,2) du circuit, de sorte qu'une différence de potentiel accrue par rapport à l'excursion ($V_L$; -$V_L$) du signal, est appliquée aux noeuds (1,2) du circuit à bascule (KS), pour son évaluation et son amplification,

- dans le cas où le signal est présent sous la forme d'un signal ayant une excursion négative (-$V_L$), ce circuit (ÜS) d'amplification du signal réalise, sur ledit noeud (1;2) du circuit, une réduction de potentiel et sur l'autre des deux noeuds (2;1), un accroissement du potentiel lors de l'activation du signal de transmission (ÜS).

2. Circuit intégrable d'évaluation suivant la revendication 1, caractérisé par le fait
   - que le circuit (SÜS) d'amplification du signal comporte au moins deux condensateurs de couplage (CK),
   - qu'une première borne d'un premier des deux condensateurs de couplage (CK) est raccordée au premier noeud (1) du circuit et qu'une première borne de l'autre des deux condensateurs de couplage (K) est raccordée au second noeud (2) du circuit,
   - que le circuit (SÜS) d'amplification du signal possède un transistor de transfert (ÜT),
     - dont la grille reçoit, comme borne de commande, un signal de transmission (ÜS),
     - dont les bornes commandées (drain, source) sont raccordées respectivement à une seconde borne du condensateur de couplage (CK),
   - qu'à la première borne des condensateurs de couplage (CK) est raccordé respectivement un transistor de séparation (TT) dont l'une des bornes (source, drain) est commandée,
     - dont la grille est chargée par un signal de séparation (TS),
     - l'autre borne commandée (drain, source) de l'un des deux transistors (TT) étant raccordé à la seconde borne de l'autre condensateur de couplage (CK), et
     - l'autre borne commandée (drain, source) de l'autre des deux transistors (TT) étant raccordée à la seconde borne du premier condensateur de couplage (CK).

3. Circuit intégrable d'évaluation suivant la revendication 2, caractérisé par le fait que les transistors de commutation (ST) sont montés de telle sorte que leur voie de commande du courant est disposée entre le couple de conducteurs de transmission de signaux (BL, RL) d'une part et le circuit à bascule (KS) ainsi que le circuit (SÜS) d'amplification du signal d'autre part.

4. Circuit intégrable d'évaluation suivant la revendication 2, caractérisé par le fait
   - que le circuit (SÜS) d'amplification du signal possède au moins un autre transistor de transfert (ÜL), dont la grille reçoit, en tant que borne de commande, le signal de transmission (ÜS),
   - qu'une borne commandée de chaque transistor de transmission (ÜT) est raccordée respectivement à la seconde borne de l'un des condensateurs de couplage (CK),
   - que l'autre borne commandée d'un transistor de transmission (ÜT) est raccordée aussi bien à l'autre borne commandée d'un premier des deux transistors de commutation (TT) que, par l'intermédiaire de la voie de conduction du courant (canal) d'un premier autre transistor de séparation (WTT), à la seconde borne de l'autre condensateur de couplage (CK),
   - que l'autre borne commandée de l'autre transistor de transfert (Ü) est raccordée aussi bien à l'autre borne commandée de l'autre des deux transistors de séparation (TT) que, par l'intermédiaire de la voie de conduction de courant (canal) d'un second autre transistor de séparation (WTT), à la seconde borne du premier condensateur de couplage (CK).

5. Circuit intégrable d'évaluation suivant la revendication 2 ou 4, caractérisé par le fait qu'on utilise comme transistors de séparation (TT), les transistors de commutation (ST).

6. Circuit intégrable d'évaluation suivant l'une des revendications précédentes, caractérisé par le fait que les valeurs des capacités des condensateurs de couplage (CK) sont différentes les unes des autres.

7. Circuit intégrable d'évaluation suivant l'une des revendications précédentes, caractérisé par le fait que les valeurs des capacités des condensateurs de couplage (CK) sont approximativement égales à la capacité propre ($C_{BW}$) du circuit à bascule (KS).

8. Circuit intégrable d'évaluation suivant la revendication 7, caractérisé par le fait que les valeurs des capacités des condensateurs de couplage (CK) sont comprises entr 20 et 40 fF.

9. Circuit intégrable d'évaluation suivant l'une des revendications précédentes, caractérisé par le fait que les transistors de transfert (ÜT) sont placés à l'état conducteur au plus tôt lorsque les transistors de séparation (TT; TT, WTT) sont bloqués.

10. Circuit intégrable d'évaluation suivant l'une des revendications précédentes, caractérisé par le fait que le flanc du signal de transmission (ÜS), qui amène ce signal à l'état actif, possède une pente inférieure à celle du flanc opposé correspondant.

11. Circuit intégrable d'évaluation suivant l'une des revendications précédentes, caractérisé par le fait que le flanc du signal de séparation (TS), qui amène ce signal à l'état actif, possède une pente. inférieure à celle du flanc opposé correspondant.

# FIG 1

# FIG 2

# FIG 3

# FIG 4